# EUROPEAN PATENT SPECIFICATION

(11) **EP 0 935 633 B1**
(45) Date of publication and mention of the grant of the patent: **28.12.2005**
(21) Application number: 97913944.1
(22) Date of filing: 31.10.1997
(51) Int. Cl.: C08J 7/06, C08F 2/46, C08F 2/48, C23C 14/02, H05H 1/00, B05D 7/24

(54) **ACRYLATE COATING METHODS**
VERFAHREN ZUR BESCHICHTUNG MIT ACRYLATEN
PROCEDES D'APPLICATION D'UN REVETEMENT D'ACRYLATE

(30) Priority: 31.10.1996 US 741609
(43) Date of publication of application: 18.08.1999
(73) Proprietor: 3M Innovative Properties Company, St. Paul, Minnesota 55133-3427 (US)
(72) Inventor: SHAW, David, G., Tucson, AZ 85718 (US); CLINE, Daniel, S., Tucson, AZ 85745 (US); DAWSON, Eric, P., Tucson, AZ 85741 (US); LANGLOIS, Marc, Tucson, AZ 85718 (US)
(74) Representative: Enskat, Michael Antony Frank
(86) International application number: PCT/US1997/019856
(87) International publication number: WO 1998/018852

(56) References cited:
- JP-A- 60 112 421
- US-A- 3 250 638
- US-A- 4 241 129
- US-A- 4 468 412
- US-A- 4 557 944
- US-A- 4 842 893
- US-A- 4 876 113
- US-A- 5 021 298
- US-A- 5 077 104
- US-A- 5 108 780
- US-A- 5 112 462
- US-A- 5 403 626
- US-A- 5 440 446
- US-A- 5 571 574

## Description

This invention concerns techniques for forming a substrate coated with a cross-linked acrylate layer which is barrier to permeation by gasses as oxygen and water vapor. Additional batter layers of metal, for example, further limit permeation. Surface preparation is an important feature of this invention.

U.S Patent No. 4,842,893 discloses coating of unstated substrates with a film of cured polyfunctional acrylate and a deposit of aluminum. It is stated that the thin film coating may be useful for food packaging or as a protective coating for metal or other substrates. The technology described in U.S Patent No. 4,842,893 is employed in additional patents such as 4,499,520, 4,584,628, 4,618,911, 4,682,565, 5,018,048, 5,032,138 and 5,125,461 for making monolithic capacitors.

Many products, including many food products, are packaged in thin plastic sheet bags or the like. The thin sheets are desirably resistant to permeation by oxygen, water vapor and odorous gases. This can, for example, be important for protecting a food from environmental gases and also for retaining the aroma of food as it is stored.

Such barrier sheets are commonly made of costly plastics because less costly films are too permeable to oxygen or water to give a long shelf life. Reduced cost barrier films are highly desirable.

U.S. Patent No. 5,021,298 describes coating of a polyolefin sheet substrate with a smooth layer of any plastic except polyvinylidene chloride and then vacuum metallizing the plastic so that the metal forms a barrier film. It is not necessary that the plastic itself be a barrier material. It would be desirable, however, to enhance the resistance of such a sheet to permeation by environmental gases, and also to provide protection for the metal against corrosion or the like.

According to the present invention there is provided a method for forming a coated substrate with a barrier film, comprising the steps of: treating a surface of a substrate with a reactive plasma utilising a reactive gas in a vacuum, and within three seconds thereafter while the substrate is still in the vacuum; evaporating an acrylate monomer composition, and condensing the acrylate monomer on the substrate as a monomer film; polymerizing the acrylate in the monomer film for forming a crosslinked acrylate layer; applying an aluminum layer of oxygen barrier material over the crosslinked acrylate layer; and switching plasma treatment to the surface of the crosslinked acrylate layer ON and OFF immediately before applying the layer of said barrier material to vary the optical density and electrical conductivity of the barrier layer.

A method for forming a coated substrate with a barrier layer and embodying the present invention will now be described with reference to the accompanying drawings, in which:
FIG. 1 is a schematic illustration of coating apparatus for forming such a capacitor sheet material;
FIG. 2 is a graph illustrating condensation efficiency as a function of temperature; and
FIG. 3 illustrates in transverse cross section a coated polypropylene with low oxygen permeability.

Barrier sheets are formed in a variety of embodiments but effectively include a substrate such as a thermoplastic polymer, a cross-link acrylate polymer and an additional barrier film such as a continuous coating of aluminum applied by vacuum metallizing. It is also desirable that the metallized layer be covered with another layer of cross-linked acrylate. All of the coatings are applied in a vacuum in a continuous process without removing the substrate from the vacuum.

The acrylate layers in the various embodiments are preferably deposited in the form of a vaporized acrylate monomer or oligomer. The monomer film is irradiated with ultraviolet or an electron beam to cause polymerization of the acrylate to form a monolithic layer. Polymerization by irradiation is a conventional practice and the electron flux required or the wavelength and total flux of ultraviolet required are commonly known.

Evaporation of the monomer is preferably from flash evaporation apparatus as described in U.S. Patent Nos. 4,722,515,4,696,719,4,842,893,4,954,371 and 5,097,800. These patents also described polymerization of acrylate by radiation. In such flash evaporation apparatus, liquid acrylate monomer is injected into a heated chamber as 1 to 50 micrometer droplets. The elevated temperature of the chamber vaporizes the droplets to produce a monomer vapor. The monomer vapor fills a generally cylindrical chamber with a longitudinal slot forming a nozzle through which the monomer vapor flows. A typical chamber behind the nozzle is a cylinder about 10 centimeters diameter with a length corresponding to the width of the substrate on which the monomer is condensed. In exemplary processes, the walls of the chamber may be maintained at a temperature n the order of 200 to 320°C.

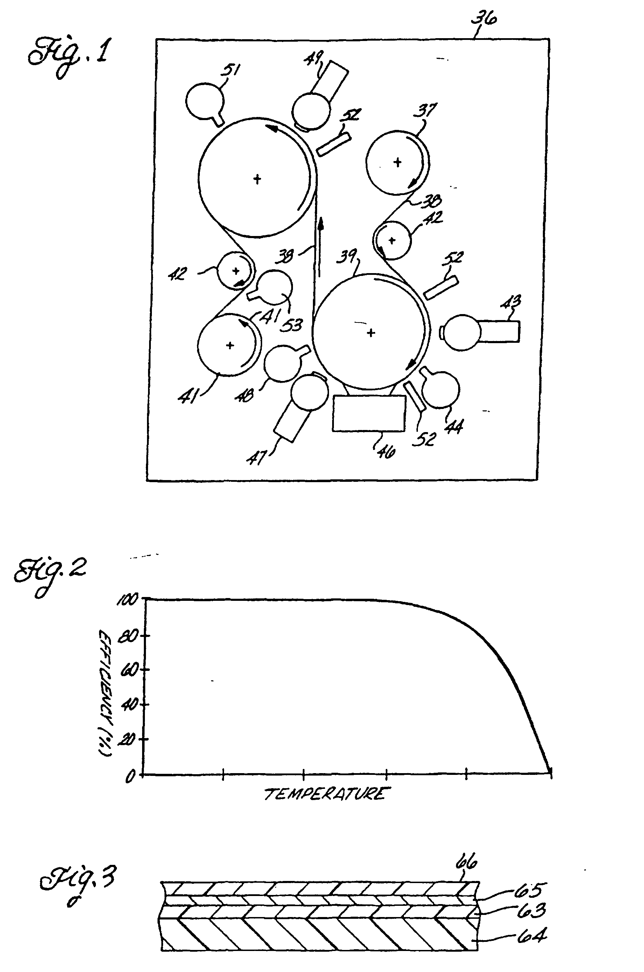

A suitable apparatus for coating the substrate with acrylate and metal layers is illustrated schematically in FIG. 1. All of the coating equipment is positioned in a conventional vacuum chamber 36. A roll of polypropylene, polyester or nylon sheet is mounted on a pay-out reel 37. The sheet 38 forming the substrate is wrapped around a first rotatable drum 39, around a second rotatable drum 40, and fed to a take-up reel 41. Idler rolls 42 are employed, as appropriate, for guiding the sheet material from the payout reel to the drums and to the take-up reel.

A flash evaporator 43 is mounted in proximity to the drum at a first coating station. The flash evaporator deposits a layer or film of acrylate monomer on the substrate sheet as it travels around the drum. After being coated with acrylate monomer the substrate sheet passes an irradiation station where the acrylate is irradiated by a source 44 such as an electron gun or source of ultraviolet radiation. The radiation or electron bombardment of the film induces polymerization of the acrylate monomer.

The sheet then passes a metallization station 46 where a coating of metal for an electrode is applied by vacuum metallizing The sheet then passes another flash evaporator 47 where another layer of acrylate monomer is deposited for forming a protective layer over the metal. This layer of monomer is cured by irradiation from an ultraviolet or electron beam source 48 adjacent the drum. Depending on whether a layer of acrylate is above or below the metal layer, either of the evaporators 43 or 47 may be used. Clearly, if the metal layer is to be sandwiched between layers of acrylate, both evaporators and their respective radiation sources are used.

The sheet then passes to the second drum 40 and past another flash evaporator 49 where another layer of acrylate monomer is deposited. This layer of monomer is cured by irradiation from an ultraviolet or electron beam source 51 adjacent the second drum. The two drums are arranged so that the first evaporators adjacent to the first drum apply acrylate to one face of the sheet and the evaporator 49 adjacent to the second drum applies a layer of acrylate to the opposite face of the sheet. The sheet coated on both faces with acrylate layers and at least one face with a metal layer is wound onto the take-up reel 41. The roll of sheet is removed from the vacuum system for use.

When a sheet is to be used for a barrier sheet, deposition may be on one face only of the sheet and the second drum may be omitted.

Exemplary acrylate resins employed from making the dielectric layer are monomers or oligomers having an average molecular weight in the range of from 150 to 600. Preferably, the monomers have an average molecular weight in the range of from 250 to 500. Higher molecular weight fluorinated acrylates or methacrylates may be equivalent to these lower molecular weight materials and also be used-for forming a deposited acrylate layer. For example, a fluorinated acrylate with a molecular weight of about 2000 evaporates and condenses similar to a non-fluorinated acrylate having a molecular weight in the order of 300. The acceptable range of molecular weights for fluorinated acrylates is about 400 to 3000. Fluorinated acrylates include monoacrylates, diacrylates, and methacrylates. Fluorinated acrylates are fast cure. Whereas methacrylates are generally too slow curing to be desirable, the fluorinated acrylates cure rapidly. Chlorinated acrylates may also be useful.

Molecular weight is the sum of the atomic weights of all of the atoms in a molecule. Atomic weight is the relative weight of an atom on the basis that the ¹²C isotope has an atomic weight of 12. Atomic weight units may be grams per gram mole or pounds per pound mole, for example. Regardless of the units, the numerical value is identical. Units of molecular weight are, therefor, rarely mentioned. As used herein, molecular weight is in units of grams/gram mole.

The molecular weight range of the acrylate may also be extended by preheating the prepolymer before it is atomized into the vaporization chamber. This lowers the viscosity and expedites evaporation. The lowered viscosity produces smaller droplets from an atomizer and enhanced evaporation. This may also permit evaporation of polymers that are solid at ambient temperatures. Either individual monomers or blends of monomers may be preheated. For example, a blend may have a major proportion of monomer with a molecular weight of about 300 and a minor proportion of another monomer with a molecular weight in the range of about 800 to 1000. Such a monomer blend may be successfully evaporated by preheating before atomizing into the vaporization chamber.

It is desirable that the thickness of the acrylate layer be sufficient for smoothing surface roughness of the underlying substrate. For example, polypropylene may have a surface roughness in the order of 1/2 to one micrometer. A layer of acrylate about two micrometers thick is adequate for smoothing the surface sufficiently to avoid steep slopes that would not readily accept vacuum metallizing.

When the monomers polymerize, there may be shrinkage of the film. Excessive shrinkage may cause poor adhesion of the layer on the substrate. Adhesion of the layer to the substrate is also dependent on thickness of the layer. A thin layer may tolerate greater shrinkage without loss of adhesion than a thick layer. Shrinkage up to about 15 to 20% can be tolerated in the thin layers used in the acrylate layers since they are very thin. However, it is preferred that the shrinkage be less than 10% for reliable coating adhesion.

To obtain low shrinkage, there should be a relatively low cross-link density. High cross-link density materials such as hexane diol. dacryolith (HDDA) and trimethylol propane dacryolith (TMPTA) have poorer adhesion than compositions with lower cross link density. A way of defining cross-link density and shrinkage is to consider the size of the molecule and the number of acrylate groups per molecule.

Preferably, the acrylate monomer has an average molecular weight to acrylate group ratio in the range of from 150 to 600. In other words, if the acrylate is a monoacrylate, the molecular weight is in the range of from 150 to 600. (Actually, it is preferred that the molecular weight of a monoacrylate be greater than 250 for other reasons.) On the other hand, if a diacrylate is used, the molecular weight may be in the range of from 300 to about 1200 and if triacrylates or other oligomers are used, the molecular weight may be higher.

Blends of acrylates of differing functionality and molecular weights may also be used. In that case, the average molecular weight to acrylate group ratio should be in the range of from 150 to 600. This range of values provides sufficiently low shrinkage of the acrylate layer upon curing that good adhesion is obtained. If the molecular weight to acrylate group ratio is too high, there may be excessive shrinkage and poor adhesion. Some examples of the ratio are as follows:

| | |
|---|---|
| trimethylol propane diacrylate | 98 |
| hexane diol diacrylate | 113 |
| beta carboxy ethyl acrylate | 144 |
| tripropylene glycol diacrylate | 150 |
| polyethylene glycol diacrylate | 151 |
| tripropylene glycol methyl ether monoacrylate | 260 |

A 50/50 blend of tripropylene glycol diacrylate and tripropylene glycol methyl ether mortoacrylate has an average ratio of 205. Higher molecular weight materials may be blended with beta carboxy ethyl acrylate (BCEA) to provide a suitable average molecular weight material.

The acrylates used may be polyol acrylates, acidic acrylates, amino acrylates and ether acrylates. Suitable acrylates not only have a molecular weight in the appropriate range, they also have a "chemistry" that does not hinder adhesion. Generally, more polar acrylates have better adhesion to metal layers than less polar monomers. Long hydrocarbon chains may hinder adhesion to metal but may be an advantage for depositing on non-polar surfaces. For example, lauryl acrylate has a long chain that is hypothesized to be aligned away from the substrate and hinder adhesion to deposited metal layers.

A typical monomer used for flash evaporation includes an appreciable amount of diacrylate and/or triacrylate to promote crosslinking. Blends of acrylates may be employed for obtaining desired evaporation and condensation characteristics and adhesion, and for controlled shrinkage of the deposited film during polymerization.

Suitable monomers are those that can be flash evaporated in a vacuum chamber at a temperature below the thermal decomposition temperature of the monomer and below a temperature at which polymerization occurs in less than a few seconds at the evaporation temperature. The mean time of monomer in the flash evaporation apparatus is typically less than one second. Thermal decomposition, or polymerization are to be avoided to minimize fouling of the evaporation apparatus. The monomers selected should also be readily capable of cross-linking when exposed to ultraviolet or electron beam radiation.

The monomer composition may comprise a mixture of monoacrylates and diacrylates. Triacrylates tend to be reactive and may polymerize at the evaporation temperatures. Generally speaking, the shrinkage is reduced with higher molecular weight materials.

Generally it is desirable that at least a major portion of the acrylate monomer evaporated is a polyfunctional acrylate for cross-linking. Preferably, the acrylate comprises at least 70 percent polyfunctional acrylates such as diacrylate or triacrylate. Preferably, the average molecular weight of the acrylate monomer or monomers is in the range of from 250 to 500. If the molecular weight is less than about 250, the monomer evaporates readily, but may not condense quantitatively on the substrate without chilling of the substrate. If the molecular weight is more than about 500, the monomers become increasingly difficult to evaporate and higher evaporation temperatures are required. As mentioned above, some fluorinated methacrylates with higher molecular weights are equivalent to lower molecular weight non-fluorinated acrylates.

Preferably, the acrylate monomer has a vapor pressure at 25°C in the range of from 1 to 20 micrometers of mercury. If the vapor pressure is less than about one micrometer, exceptionally high temperatures may be required to evaporate sufficient material for forming a coating on the sheet substrate at reasonable coating speeds. High temperatures may lead to thermal decomposition or premature curing of the monomers. If the vapor pressure is higher than about twenty micrometers of mercury, condensation of the monomer to form a film on the substrate may have too low an efficiency for practical coating operations. Adequate efficiency may not be obtained until the surface of the substrate is cooled below the freezing point of the monomer, in which case the material may not polymerize properly.

There are at least five monoacrylates, ten diacrylates, ten to fifteen triacrylates and two or three tetraacrylates which may be included in the composition. Most preferably the acrylate comprises hexane diol diacrylate (HDDA) with a molecular weight of 226 and/or tripropylene glycol diacrylate (TRPGDA) with a molecular weight of about 300. Other acrylates may be used, sometimes in combination, such as monoacrylates lauryl acrylate (M.W. 240) or epoxy acrylate RDX80095 made by Radcure of Atlanta, Georgia; diacrylates diethylene glycol diacrylate (M.-W. 214), neopentyl glycol diacrylate (M.W. 212), propoxylated neopentyl glycol diacrylate (M.W. 328) and polyethylene glycol diacrylate, tetraethylene glycol diacrylate (M.W. 302), and bisphenol A epoxy diacrylate; and triacrylates trimethylol propane triacrylate (M.W. 296), ethoxylated trimethylol propane triacrylate (M.W. 428), propylated trimethylol propane triacrylate (M.W. 470) and pentaerythritol triacrylate (M.W. 298). Monomethacrylates and dimethacrylates triethylene glycol dimethacrylate (M.W. 286) and 1,6-hexanediol dimethacrylate (M.W. 254) may also be useful, but may cure too slowly to be useful for high speed coating operations.

It is known that adhesion may be enhanced between a sheet and an acrylate coating, by using an acrylate containing high molecular weight components. In practice very high molecular weight oligomers are usually mixed with low molecular weight monomers. The oligomers usually have molecular weights of greater than 1000 and often as large as 10,000 or even higher. The monomers are used as diluents to lower the coating viscosity and provide an increased number of acrylate groups for enhancing cure speed, hardness and solvent resistance in the resulting coating.

It has generally been considered that it is not feasible to evaporate high molecular weight acrylates because of their very low vapor pressure and high viscosity. Evaporated acrylate coatings have been restricted to low molecular weight monomers, generally below a molecular weight of about 400 and with low viscosity. Generally the viscosities are below 50 centistoke. For example, Henkel 4770, which is an amine acrylate, has a sufficiently high molecular weight that it has a viscosity of about 1000 centistokes at 25°C. This material cures in the evaporator before evaporating. Beta carboxy ethyl acrylate (BCEA) which has a viscosity of over 200 centistokes also cures in the evaporator.

It has been found, however, that by mixing a very low and a very high viscosity material, flash evaporation, condensation and curing can be obtained. For example, a mixture of 70 percent of Henkel 4770 and 30 percent diethylene glycol diacrylate has a viscosity of about 12 centistokes and can be successfully evaporated, condensed and cured. A mixture of 70 percent tripropylene glycol diacrylate (TRPGDA) and 30 percent of beta carboxy ethyl acrylate (BCEA) has a viscosity of about 15 centistokes and can be readily evaporated, condensed and cured. The low viscosity component lowers the viscosity of the blend, which improves atomization in the evaporator and assists in the flash evaporation of the high viscosity acrylate.

There is essentially a trade off between the molecular weights (and hence viscosities) of the high and low molecular weight acrylates. Generally, the lower the molecular weight and viscosity of the low molecular weight component, the higher the molecular weight and viscosity of the higher molecular weight component can be for satisfactory evaporation and condensation. The reason for good atomization in the flash evaporator is straightforward. This is essentially a physical effect based on the viscosity of the blend. The reason for successful evaporation is not as clear. It is hypothesized that the low molecular weight acrylate essentially dilutes the high molecular weight material and energetic evaporation of the lower molecular weight material effectively sweeps along the higher molecular weight material.

When blends of high and low molecular weight acrylates are used, it is preferred that the weighted average molecular weight of the blend be in the range of from 250 to 600 and preferably up to about 500. This assures that there is good vaporization of the blend at reasonable temperatures in the evaporator.

Some examples of low molecular weight acrylates are hexane diol diacrylate, diethylene glycol diacrylate, propane diacrylate, butane diol diacrylate, tripropylene glycol diacrylate, neopentyl glycol diacrylate, phenoxyethyl acrylate, isobomyl acrylate and lauryl acrylate. Some examples of high molecular weight acrylates are bisphenol A diacrylate, BCEA, Radcure 7100 (an amine acrylate available from Radcure, Atlanta Georgia), Radcure 169, Radcure 170, acrylated and methacrylated phosphoric acid, Henkel 4770 (an amine acrylate available from Henkel Corporation, Ambler, Pennsylvania) and glycerol propoxy triacrylate.

Particularly preferred high molecular weight materials include BCEA which is acid in character and has a shrinkage of only about 4 percent upon curing. Another suitable material is an acrylate or methacrylate of phosphoric acid. One can also use dimers, trimers and tetramers of acidic acrylates or methacrylates. For example, Henkel 4770 is polar and helps increase the cure speed and adhesion. In general, the higher molecular weight components are used to add flexibility, reduce shrinkage or provide some particular chemical characteristics such as acid or caustic resistance.

It has been found that the temperature of the substrate on which the monomer film is deposited can have a large influence on the efficiency of condensation. The effect of temperature depends on the particular monomer. An exemplary indication of the efficiency as a function of temperature is illustrated in the graph of FIG. 2. At low surface temperatures such as close to 0°C, there is essentially 100% efficiency and all of the monomer condenses. At a somewhat higher temperature, such as for example, 20°C, little, if any, of the monomer actually condenses on the substrate. It can be seen that in some temperature ranges the efficiency of condensation is quite sensitive to relatively small changes in temperature. Thus, for efficient condensation, the surface of the substrate should be chilled below 0°C. When chilling of the sheet is on a chilled backup drum, much lower temperatures are required on the drum surface. One can determine when the surface is sufficiently chilled even though direct temperature measurement of the sheet is difficult. If the surface is higher than about 0°C, there is poor condensation efficiency.

For higher molecular weight, less volatile monomers or oligomers, the critical chilling temperature of the surface may be higher than 0°C. For such materials the surface temperature should be less than 10°C.

Because the efficiency of condensation changes rather steeply and since the flash evaporation and irradiation tend to raise the temperature of the substrate, it is desirable to refrigerate the roll of substrate until it is placed on the pay-out reel in the coating apparatus. Thus, the roll of sheet material may be stored in a low temperature refrigerator. It is also desirable to cool the rotating drums, such as for example, with chilled water and ethylene glycol solutions, so that the substrate remains at a low temperature. For lowest temperatures, silicone liquids may be needed.

When the sheet being coated is smooth and thin (generally less than 12 micrometers) good condensation efficiency can be obtained with monomers having a molecular weight of at least 250 with the backing drum cooled to temperatures in the range from -15°C to -35°C. This has been observed with either polypropylene or polyester sheet coated at speeds in the range from about 80 to 330 meters per minute. When thicker sheet is used, condensation efficiency may decrease dramatically. For example, polypropylene sheet having a thickness of about 20 micrometers showed a condensation efficiency below 70% when coated at comparable speeds with a drum temperature less than about -9°C. These tests were made without precooling the substrate on the payout reel. Thus, it appears as though there is not enough time for the cooling to fully penetrate the substrate sheet as it moves over a chilled coating drum at high speed. Therefore, the exposed face of the sheet is not cool when it is exposed to the acrylate vapor.

Fig. 2 includes a series of data points showing measured condensation efficiencies of hexane diol diacrylate monomer as a function of the substrate temperature. HDDA is a relatively volatile monomer with a molecular weight about 212. A less volatile monomer such as tripropylene glycol diacrylate with a molecular weight of about 300 has higher condensation efficiency. However, even this material requires some degree of cooling.

The molecular weight of the monomer should not be increased too much because the vapor pressure decreases rapidly with increasing molecular weight. To evaporate very high molecular weight monomers such as above about 600, the evaporator temperature needs to be increased to as much as 350°C. Such extreme evaporator temperatures can degrade the monomer molecules. Preferably, the acrylate monomer molecular weight is kept below about 600.

An extreme amount of cooling of the substrate must also be avoided. For example, HDDA freezes on the substrate when the coating drum temperature is below about 0°C. The frozen monomer cannot be polymerized. Thus, the cooling temperature must hold the surface of the substrate above the freezing point of the monomer but below the temperature at which the condensation efficiency decreases significantly. For commercially acceptable deposition, condensation efficiency should exceed 90%. Loss of material due to low condensation efficiency is less of a concern than the collection of stray condensate in vacuum chambers, pumps and other equipment. Preferably, the condensation efficiency approaches 99%.

As an alternative to or in addition to precooling the roll of substrate the sheet can be cooled on the front surface preceding the evaporator. For example, the idler roll 42 between the payout reel and the first drum may be chilled for cooling the front surface of the substrate sheet before it reaches the first drum. To get the front face of the substrate sheet at a sufficiently low temperature for efficient condensation, the roller contacting the front face should be chilled below 0°C, and preferably below -15 °C.

It may also be desirable to lift the sheet off the principal deposition drum after depositing metal and pass the front surface of the sheet over a chilled roller for cooling the metallized surface. Vacuum deposition of aluminum on the surface heats the sheet and it is found that additional cooling after deposition enhances deposition efficiency and makes improved coatings. This may not be a suitable technique for coating a barrier sheets since contact of the unportected metal coating with a roller can cause sufficient microscopic damage to the surface that the barrier properties are degraded. Preferably, the metallized surface is coated with an acrylate which is cross-linked before the coated surface of the sheet contacts any solid surfaces.

One may also cool the front surface of a substrate by way of a chilled idler roll, for example, and then deposit metal on the chilled front surface. This initial chilling may be sufficient that an overlying acrylate layer can be successfully deposited on the prechilled substrate.

It might also be noted that in applications where the surface of the substrate being coated with acrylate monomer is relatively rough, precooling by way of the rotating drum may not be adequate and precooling of the roll of substrate sheet may be required. For example, deposits were made on 9 micrometer thick translucent polypropylene sheet with relatively low deposition efficiency. The sheet has a surface roughness of about ½ to 1 micrometer. The drum behind the sheet on which the acrylate was deposited was cooled to a temperature of about 0 to 4 °C. The condensation efficiency was less than about 70 percent since the rough sheet did not make good thermal contact with the chilled drum. This can be compared with smooth sheet with comparable thickness and coating speed where the deposition efficiency is about 99 percent. Precooling the roll of sheet before placing it in the vacuum apparatus also restores high efficiency condensation.

Precooling of a sheet of material on which the acrylate is to be deposited can be significant for applications in addition to preparation of sheet material for winding capacitors. For example, there are times that it is desirable to coat paper with an acrylate and the rough surface of paper does not lend itself to cooling from the back surface on a rotating drum. Similarly, when the sheet being coated is relatively thick so that there is insufficient time to cool the entire thickness of the sheet, precooling may be important.

Surprisingly, when a technique as described for forming an acrylate layer on a polypropylene substrate was tried, the acrylate monomer could not be cured, even by intense irradiation with an electron gun. It was found that acrylate monomer condensed to form a film on the polypropylene substrate but it could not be polymerized. The electron gun current was increased by a factor of five and the electron beam voltage was doubled from about 10 kV to about 20 Kv. The coating speed was reduced from about 150 meters per minute to less than 40 meters per minute and that still did not result in a cure. It was known that there was adequate electron flux and sufficient energy to completely penetrate the acrylate layer, but the coating did not cure.

It is hypothesized that the surface of untreated polypropylene sheet takes on a negative charge during the curing process which can repel the incoming electron beam. Polypropylene is an outstanding insulator. The excellent insulation provided by the polypropylene facilitated the formation of a surface charge.

It was found that curing an acrylate monomer on a polypropylene substrate is feasible once the surface conductivity of the sheet is increased. This can be correlated with surface tension. Untreated polypropylene sheet has a surface tension of about 25 to 32 dynes/cm². Corona treated polypropylene has a surface tension in the order of about 29 to 33 dynes/cm². It was shown that an acrylate coating on a sheet of polypropylene with a surface tension of about 34 to 35 dynes/cm₂ could not be cured with the electron beam. It was also shown, however, that a polypropylene sheet with a surface tension of about 36 to 40 dynes/cm² could be readily coated and cured. Surfaces treated to have a tension as high as 56 dynes/cm² have been tested and acrylate monomer films can be easily cured by electron bombardment.

The treatment of the surface is beneficial for polyester and other non-conductive surfaces, but the effect is not as dramatic as with polypropylene.

The surface conductivity of the polypropylene sheet can be modified before any of the coating steps described above by a pretreatment, or a surface treatment may be applied in-line in the same process as the coating operation. The most common technique for treating the substrate sheet on an off-line basis is to expose it to a corona discharge in air or nitrogen. This activates the substrate surface and also oxygen and nitrogen which react with the activated surface. These chemical groups are apparently incorporated onto the surface and change the surface conductivity and surface tension.

During investigation of alternative techniques for treating the surface of a sheet, it has been discovered that surface treatment within the vacuum chamber is of substantial importance for all surfaces, not just the surface of the raw sheet. Prior treatments in air may produce a benefit that decays with time. Furthermore, as mentioned above, corona treatment of polypropylene does not raise the surface energy to a point where electron beam curing of the acrylate can be obtained at all.

Thus, it is found desirable to treat the surface to be coated with a reactive plasma immediately before coating. A conventional plasma gun 52 is positioned in the vacuum chamber upstream from each of the flash evaporators 43 and 49 for activating the surface of the sheet on a continuous basis before monomer deposition. Most important is the plasma treatment of the surface of the uncoated sheet before the first application of an acrylate coating. Another plasma gun 52 is provided immediately before the vacuum metallizing station 46. Conventional plasma generators are used.

In an exemplary embodiment the plasma generator is operated at a voltage of about 500 to 1000 volts with a frequency of about 50 Khz. Power levels are in the order of 500 to 3000 watts. For an exemplary 50 cm wide sheet traveling at a rate of 30 to 90 meters per minute, around 500 watts appears appropriate.

It has also been found important to operate the plasma generator with a reactive gas. Argon and helium have been shown to have virtually no effect on adhesion. Oxygen, nitrogen, nitric oxide (NO), nitrous oxide (NO₂) and mixtures such as clean air are suitable reactive gases to use in the plasma.

It is been found that without reactive plasma treatment of the surface there can be poor adhesion of the deposited materials. The thickness of the film deposited and the chemistry of the acrylate are factors subordinated to the surface preparation. Furthermore, without reactive plasma treatment of the surface of an uncoated sheet, the acrylate deposited on the surface may not be curable at all with an electron beam.

It is hypothesized that the reactive species (ions and electrons) in the plasma disrupt carbon-carbon and carbon-hydrogen bonds in the substrate polymer. The reactive ions may combine with the disrupted bonds or the bonds may remain open and provide reactive sites for reaction with the acrylate monomers or oligomers. Furthermore, the surface of the substrate probably contains condensed contaminants such as water and organic molecules from its original processing and exposure to air before introduction into the vacuum. It is known that some organic molecules, particularly silanes and some industrial solvents, are so highly adsorbed on surfaces and interfere with surface chemistry that the presence of the chemicals in some processing facilities is absolutely prohibited. That chemical changes occur on the surfaces of the substrate is confirmed by tests where an acrylate coating was applied over a surface containing a release layer such as a wax or silicone material. Such a surface was treated with a reactive plasma and an acrylate was deposited on the treated surface and cross-linked by electron beam irradiation. It was found that the release coating was no longer effective and that the coating could not be removed from the substrate.

It is important that the activated surface produced by reactive plasma treatment be promptly coated with the acrylate monomer or oligomer. The highly reactive surface produced may combine with water or other species in the system that would inhibit adhesion. Coating within less than three seconds is important and typical time between reactive plasma treatment and coating is in the order of 1/2 second to as little as 1/10 second.

It is also important that both the reactive plasma treatment and the coating occur in vacuum that prevents contact with water or other species of molecule that would inhibit adhesion. A vacuum in the order of 10⁻² to 10⁻⁴ Torr is usual and pressures less than 10⁻² are important.

It is hypothesized that during the deposition process there may be times when evaporated acrylate monomer is distributed within the vacuum chamber. This monomer may condense on cooler sheet before the sheet reaches the evaporation station or between the curing station and the metallization station. In the activated environment within the vacuum chamber, some of the monomer may be partially reacted and thereby form an intervening layer between the substrate and deposited coating that reduces adhesion. The acrylate, for example, cures most efficiently when the entire layer of acrylate cures at once. Thus, it is important to remove the partially cured layer of condensed acrylate before further deposition. Plasma treatment may effect such removal and be useful before or after metallizing.

There is evidence that acrylate monomer is depositing on the sheet. The monomer has a characteristic odor which is not present in the crosslinked acrylate. The odor can be detected on a variety of surfaces after removal from the vacuum chamber. For example, one can coat a sheet of paper with an acrylate layer which is cured, followed by metallizing. An acrylate odor can be detected on both the front and back faces of the sheet.

Sequential plasma treatments for removing deposited acrylate monomer may be minimized by partitioning the evaporator from the rest of the vacuum chamber. For example, tight fitting baffles cooled with liquid nitrogen can serve to condense stray monomer from the evaporator and provide a tight or tortuous path for minimizing transmission of the monomer that does not condense. Separate vacuum systems may be applied to some of the regions for removing acrylate vapor so that it does not condense in undesired locations.

An initial plasma treatment before the first coating of acrylate remains of critical importance, however. Commercially available plastic sheets appear to have surface contamination that interferes with adhesion and removing the contamination before depositing metal or acrylate is desirable. Such surface contamination may be from processing aids used in the manufacture of the sheet, non-polymerized constituents of the sheet or materials that deposit on the sheet after its original fabrication.

Interestingly, with sheets that are pre-metallized on one face before loading in the vacuum chamber, there appears to be a film on top of the metal which interferes with adhesion of an acrylate. It is hypothesized that interfering materials on the back face of the sheet which is not metallized are in part transferred to the metallized face while the material is in a roll. Significantly enhanced adhesion is obtained by plasma treating the metal layer before depositing an acrylate monomer.

A surprising discovery is that treating a substrate or acrylate surface with a reactive plasma immediately before metallizing significantly improves the metal coating. Adhesion of aluminum on a cross-linked acrylate can be poor. Reactive plasma treatment yields good adhesion. In addition, when depositing aluminum, for example, the optical density of the aluminum coating increases about 20% after reactive plasma treating as compared with the identical coating without plasma treatment. This can be seen by simply turning the plasma generator on and off and a virtually instantaneous change in optical density can be seen. Furthermore, the electrical conductivity of the aluminum film increases about 15 to 20% when the surface has been treated with a reactive plasma immediately before vacuum metallizing. These effects occur without increasing the amount of aluminum deposited per unit area.

When the density and conductivity are significantly increased by reactive plasma treatment of the surface before metallizing, there is a very beneficial result. The coating apparatus can be operated up to 20% faster with plasma treatment than without, without any decrease in film quality.

The plasma treatment is clearly distinct from corona treatment in air. The effects of plasma treatment can be observed on polypropylene that has already been corona treated. It is considered important that the plasma treatment precede the metallizing by only a very short interval and within the same vacuum. If a surface is plasma treated, removed from the vacuum and then later metallized, some of the benefits of plasma treatment are disipated.

A substrate may also be coated with a radiation curable acrylate by mechanical processes instead of the evaporation techniques described above. In such a case a relatively viscous liquid oligomer is used as the coating material. The coating can be by usual extrusion coating, roller coating, gravure coating, doctor blades, or the like. The molecular weight of the materials used for such coating is in the range of about 1000 to 50,000 as appropriate for the coating technique, thickness of coating and coating speed desired. It has been found that it is not necessary to specially degas higher molecular weight oligomers when used for coating as compared with low molecular weight monomers. The oligomers have much higher viscosity and apparently less ability to dissolve gases and high vapor pressure molecules that might interfere with vacuum processing. Furthermore, the higher viscosity of the oligomers as compared with monomers may make the release of any dissolved materials inconsequential.

It is important to treat the surface of the plastic sheets with a reactive plasma in vacuum promptly before roll coating or the like just as it is important when depositing acrylate by evaporation and condensation. This is important when trying to cure a coating with electron beam. It is also important to assure adhesion to the underlying substrate. Thus, a process for coating a sheet with a radiation curable acrylate by roll coating or the like would be as follows:

A roll of sheet material is placed in a vacuum chamber which is pumped down to low pressure. A vacuum of something less than 100 microns (10⁻¹ Torr) may be sufficient when an acrylate is cured by irradiation with ultraviolet. A greater vacuum, in the order of 10⁻⁴ Torr is preferred for electron beam curing and for evaporative coating of metals. Sheet material is unrolled and the surface to be coated is passed through a plasma treating station where it is exposed to a reactive plasma. The sheet then promptly passes through coating apparatus where a thin film of liquid oligomer is applied to the treated surface. The sheet than passes an electron beam curing station where the oligomer film is irradiated with an electron beam for cross linking the oligomers. The sheet than passes to a vacuum metallizing station for application of a film of aluminum with or without an additional plasma treatment. Finally, another acrylate film is applied and cross linked for protecting the metallized film. The second acrylate film is applied before the metallized coating contacts any solid surface, such as another roller, which could introduce imperfections into the film. The second coating may be applied by roll coating since contact of the metallized film with a wet roller does not seem to introduce imperfections that degrade the barrier properties of the film.

Coating of plastic sheets with crosslinked acrylate and/or metal significantly enhances the barrier properties of the sheet for use in packaging. When sheets used in packaging food products, cigarettes or many other items, the presence of an acrylate odor is unacceptable. Any such odor can be eliminated by curing any residual acrylate monomer on the sheet before it is removed from the vacuum.

An electron gun 53 is mounted in the vacuum chamber between the final idler roll 42 and the take-up reel 41. Electron bombardment from the gun polymerizes any residual acrylate monomer on the surfaces of the sheet before it is rolled up. Ultraviolet radiation could be used instead. The electron gun is arranged to irradiate the sheet in the converging region between the sheet on the take-up reel and the sheet advancing from the idler roll. By irradiating in this converging space both faces of the sheet can be irradiated with a single electron gun. When the vacuum system is kept clean and stray acrylates are prevented from condensing on the sheet, a final curing step may not be important.

As has been mentioned, the nozzle for the flash evaporator typically comprises a slot extending longitudinally along the evaporator chamber. In an exemplary evaporator, the nozzle slot may have a width in the range of from 0.75 to 1 mm. The surface of a substrate on which the monomer is condensed may be moved past the nozzle at a distance from the nozzle of about 2 to 4 mm. Typical speed of traverse of the substrate past the nozzle is in the order of 100 to 500 meters per minute.

It has been found that polypropylene, polyester or nylon sheets with thin surface coatings of evaporated and crosslinked acrylate have very low oxygen permeability. There is a great need for low cost packaging materials for food products, for example, where the oxygen permeability of the package is low for preserving the freshness of the packaged goods. Metallized plastic sheet is used for this purpose. Typical sheets for packaging foodstuffs include metallized nylon or polyester sheet. Metallized nylon has an oxygen permeability of about 0.05 ml/100 in²/hour (ml/645 cm²/hour) as measured with a Mocon Oxtran System available from Modem Controls, Minneapolis, Minnesota. Metallized polyester has a typical oxygen permeability of about 0.08. Metallized polypropylene, on the other hand, has an oxygen permeability of about 2.5 and is not usually suitable for packaging where low oxygen permeability is important.

It is believed that the high oxygen permeability of metallized polypropylene is due to the inherent surface roughness of the polypropylene sheet. Nylon and polyester sheets are considerably smoother and a metal coating of uniform thickness can be readily applied as a good oxygen barrier. Typically, polypropylene may have a surface roughness in the order of 1/2 to one micrometer, or more in some sheets. A layer of acrylate about two micrometers thick is adequate for smoothing the surface for producing a surface that will accept a barrier coating sufficiently continuous for low oxygen permeability.

Sheet polypropylene without any coating may have an oxygen permeability of about 100. However, if a layer of aluminum 65 is applied to a surface of a polypropylene sheet substrate 64, the oxygen permeability decreases to about 2.5. Surprisingly, when an acrylate layer 63 only about one micrometer thick is formed on the polypropylene and then covered with a layer of metal 65, the oxygen permeability drops to about 0.05, a value lower than metallized polyester. It is hypothesized that the film of liquid acrylate monomer deposited on the surface of the polypropylene has a smooth, high temperature surface and the surface remains smooth when the acrylate is polymerized. The metallized layer can then form a good oxygen barrier. Coating with aluminum as a barrier film is usually preferred.

A transparent barrier film may be formed on a polyethylene, polypropylene, polyester or nylon substrate, or on other sheets, including paper. First, a layer of acrylate monomer is deposited on the substrate and crosslinked. The acrylate layer is then coated with a layer of SiOₓ or aluminum oxide, both of which have good resistance to oxygen permeability. The high temperature resistance of the acrylate layer permits the notably higher temperature deposition of silicon oxide or aluminum oxide on the thermoplastic substrate. Typical techniques for depositing these materials may include sputtering aluminum or silicon in an oxygen plasma atmosphere for depositing the oxide, or plasma enhanced chemical vapor deposition. With these processes, a separate plasma surface treatment preceding the deposition of the transparent oxide may not be required.

A still greater surprise occurs when another polymerized acrylate layer 66 is formed over the metal or oxide barrier layer. The permeability through a polypropylene barrier material with an acrylate layer, a metal layer and an acrylate layer drops to about 0.002 which is appreciably better than the oxygen permeability of metallized nylon. The second acrylate layer protects the metallized layer and assures retention of the oxygen barrier properties of the metal. Oxygen barriers are further enhanced by multiple layers, such as, for example, a thermoplastic substrate with layers of acrylate, metal, acrylate, metal and acrylate. Furthermore, when multiple coating layers are applied, any pinholes or other local defects in a layer are likely to be offset from similar pinholes or defects in underlying layers. Thus, oxygen permeability through pinholes is effectively eliminated.

It has been found important to adequately protect the metallized film from mechanical damage to maintain low oxygen permeability. A topcoat of crosslinked acrylate applied over the metal film provides protection. If one contacts the metallized surface of a substrate against a roller in the vacuum system, inspections shows that a large number of microscopic areas have the metal film disrupted. These pinholes are large sources of leakage through the film. On the other hand, applying a topcoat of crosslinked acrylate to protect the metal permits the sheet to be handled without special precautions to avoid contact with solid surfaces.

One may also provide protection to the metallized film before it contacts any solid surface by roll coating or the like with a wet roller. The oligomers applied by roll coating are crosslinked by electron beam irradiation. Another technique is to laminate another sheet over the metallized film. A thin sheet of protective plastic has an adhesive applied and is brought into contact with the metal in a typical laminating process. Alternatively, one may use a hot melt technique where a thin sheet of polyethylene, for example, has a surface melted and brought into contact with the metal film before the surface solidifies, so that the sheet adherest to the metal.

A preferred sheet of material with low oxygen permeability has a layer of polymerized acrylate, a layer of barrier material and another layer of polymerized acrylate on a sheet plastic substrate. The layers of acrylate reduce permeability dramatically and the layer overlying the barrier material protects the barrier material from mechanical damage and corrosion, and also provides a surface suitable for printing.

A substantial improvement in oxygen permeability is believed to be attributable to formation of a liquid film of monomer on the surface of the polypropylene, followed by cross linking of the polyfunctional acrylate. Applying the layer by condensing from the vapor phase assures smooth and uniform coating of the substrate, thereby forming an excellent surface for receipt of the metallization. Cross linking upon curing the acrylate produces a material having low inherent oxygen permeability. Adding a second layer of acrylate monomer which is polymerized in situ is believed to rectify any defects in the underlying layers and provide an additional thickness of material with inherently low oxygen permeability.

The polymerized acrylate layer is believed to be beneficial for a number of other reasons. As a thermoset material, it has higher temperature resistance than the thermoplastic substrate. In the coating process, the sheets are subjected to elevated temperature processing such as metallizing, plasma treatment and the like. Particularly high temperatures may be encountered when depositing transparent barrier coatings. Various volatile materials, such as water vapor or plasticizers, may be emitted by thermoplastic surfaces under these conditions. These may adversely affect the properties of the coating such as adhesion, nucleation and growth, and thereby reduce the barrier properties. A cured acrylate coating would not have such emissions and may seal the surface and inhibit emission of such materials from a thermoplastic substrate.

The acrylate layer is substantially free of volatile materials because of the vacuum processing. Any volatile materials included in a monomer evaporate with the monomer. Since the monomer barely condenses on the substrate at usual deposition temperatures, volatile materials do not condense and disappear into the vacuum pumps. In effect, the monomer is vacuum distilled during processing. Use of oligomers for forming the acrylate layer typically avoids the presence of potentially volatile materials which have low affinity for the oligomers.

A polypropylene sheet coated with a layer of polymerized acrylate and a metallized layer, and preferably coated with an additional layer of polymerized acrylate, not only has lower oxygen permeability than prior materials it also has a lower cost. Such material should find wide application as low oxygen permeability packaging sheet.

In applications where a transparent oxygen barrier is applied or in some applications with a metallized layer, a layer of acrylate shows a slightly colored or tinted appearance due to interference patterns. Packagers find such an appearance undesirable. In such cases an acrylate layer having a thickness of about 1.2 to 1.5 micrometers can avoid the interference colors.

Many modifications and variations in the coating of thermoplastic sheets for low oxygen permeability will be apparent to those skilled in the art. For example, the sequence of coating operations and the coated substrate may be varied appreciably.

The description has been concentrated on the coating of sheet substrates. It may also be desirable to coat three dimensional objects such as cosmetic or medical containers. The same principles may be used for these objects as well. For example, it has been found desirable to chill a roll of sheet before placing it in the vacuum chamber so that monomer quantitatively condenses on the chilled surface. Racks of containers may also be chilled before placing in the vacuum chamber and promptly processed so that condensation is enhanced. Adhesion to such surfaces may also be enhanced by reactive plasma treatment immediately before deposition of the first acrylate layer.

Thus, it will be understood that within the scope of the following claims this invention may be practiced otherwise than as specifically described.

## Claims

1. A method for forming a coated substrate with a barrier film, comprising the steps of:
treating a surface of a substrate with a reactive plasma utilising a reactive gas in a vacuum, and within three seconds thereafter while the substrate is still in the vacuum;
evaporating an acrylate monomer composition, and condensing the acrylate monomer on the substrate as a monomer film;
polymerizing the acrylate in the monomer film for forming a crosslinked acrylate layer;
applying an aluminum layer of oxygen barrier material over the crosslinked acrylate layer; and
switching plasma treatment to the surface of the crosslinked acrylate layer ON and OFF immediately before applying the layer of said barrier material to vary the optical density and electrical conductivity of the barrier layer.

2. A method as recited in Claim 1, comprising the steps of:
chilling the substrate to a temperature below 10°C outside of a vacuum;
introducing the chilled substrate into a vacuum; and
condensing the acrylate monomer on a surface of the substrate while the temperature of the surface of the substrate is still below 10°C.

3. A method as recited in Claim 1, wherein the substrate comprises a sheet material comprising the steps of:
engaging a first face of the substrate with a chilled roller,
performing the plasma treating step on the first face and immediately thereafter;
moving the substrate past a deposition station for depositing the acrylate monomer on the first face; and
crosslinking the monomer on the first face.

4. A method as recited in Claim 3, further comprising the steps of engaging the other face of the sheet material substrate with a chilled drum and rotating the drum past the deposition station for depositing the acrylate monomer on the first face.

5. A method according to Claim 1, wherein the uncoated substrate is a sheet material and **characterised by** the step of engaging a first face of the uncoated sheet material substrate with a chilled drum and rotating the drum past a deposition station for depositing the acrylate monomer composition on a second face of the uncoated sheet material substrate opposite the first face, wherein the drum is chilled to a temperature less than -15°C.

6. A method according to Claim 1, **characterised in that** the acrylate monomer composition comprises at least one of hexane diol diacrylate, diethylene glycol diacrylate, propane diacrylate, butane diol diacrylate, tripropylene glycol diacrylate, neopentyl glycol diacrylate, phenoxyethyl acrylate, isobornyl acrylate and lauryl acrylate.

7. A method according to Claim 1, wherein the acrylate monomer composition comprises at least one of bisphenol A diacrylate, beta carboxy ethyl acrylate, amine acrylate, acrylated and methacrylated phosphoric acid and glycerol propoxy triacrylate.

## Patentansprüche

1. Verfahren zur Herstellung eines beschichteten Substrats mit einem Barrierefilm, umfassend die Schritte:
Behandeln einer Oberfläche eines Substrats mit einem reaktiven Plasma unter Verwendung eines reaktiven Gases in einem Vakuum, und innerhalb von 3 Sekunden danach, während sich das Substrat nach wie vor in dem Vakuum befindet;
Verdampfen einer Acrylatmonomerzusammensetzung und Kondensieren des Acrylatmonomers auf dem Substrat als ein Monomerfilm;
Polymerisieren des Acrylats in dem Monomerfilm, um eine vernetzte Acrylatschicht zu bilden;
Aufbringen einer Aluminiumschicht als Sauerstoffbarrierematerial über der vemetzten Acrylatschicht; und
Einschalten der Plasmabehandlung der Oberfläche der vernetzten Acrylatschicht und Ausschalten unmittelbar bevor die Schicht des Barrierematerials aufgebracht wird, um die optische Dichte und elektrische Leitfähigkeit der Barriereschicht zu variieren.

2. Verfahren gemäß Anspruch 1, umfassend die Schritte:
Abkühlen des Substrats auf eine Temperatur unter 10°C außerhalb eines Vakuums;
Einbringen des gekühlten Substrats in ein Vakuum; und
Kondensieren des Acrylatmonomers auf einer Oberfläche des Substrat, während die Oberflächentemperatur des Substrats noch unter 10°C ist.

3. Verfahren gemäß Anspruch 1, wobei das Substrat ein flächenförmiges Material umfasst, umfassend die Schritte:
in Verbindung bringen einer ersten Fläche des Substrats mit einer gekühlten Rolle;
Durchführen des Plasmabehandlungsschritts auf der ersten Fläche und unmittelbar danach;
Vorbeiführen des Substrats an einer Abscheidungsstation zur Abscheidung des Acrylatmonomers auf der ersten Fläche; und
Vernetzen des Monomers auf der ersten Fläche.

4. Verfahren gemäß Anspruch 3, weiterhin umfassend die Schritte in Verbindung bringen der anderen Fläche des flächenförmigen Materialsubstrats mit einer gekühlten Trommel und Rotieren der Trommel vorbei an einer Abscheidungsstation, um das Acrylatmonomer auf der ersten Fläche abzuscheiden.

5. Verfahren gemäß Anspruch 1, wobei das unbeschichtete Substrat ein flächenförmiges Material ist und das **gekennzeichnet ist durch** den Schritt in Verbindung bringen einer ersten Fläche des unbeschichteten flächenförmigen Materialsubstrats mit einer gekühlten Trommel und Rotieren der Trommel vorbei an einer Abscheidungsstation, um die Acrylatmonomerzusammensetzung auf einer zweiten Fläche des unbeschichteten flächenförmigen Materialsubstrats entgegengesetzt der ersten Fläche abzuscheiden, wobei die Trommel auf eine Temperatur von weniger als -15°C gekühlt ist.

6. Verfahren gemäß Anspruch 1, **dadurch gekennzeichnet, dass** die Acrylatmonomerzusammensetzung mindestens eines aus Hexandioldiacrylat, Diethylenglykoldiacrylat, Propandiacrylat, Butandioldiacrylat, Tripropylenglycoldiacrylat, Neopentylglycoldiacrylat, Phenoxyethylacrylat, Isobomylacrylat und Laurylacrylat umfasst.

7. Verfahren gemäß Anspruch 1, wobei die Acrylatmonomerzusammensetzung mindestens eines aus Bisphenol-A-diacrylat, Betacarboxyethylacrylat, Aminacrylat, acrylierte und methacrylierte Phosphorsäure und Glycerinpropoxytriacrylat umfasst.

## Revendications

1. Procédé pour former un substrat revêtu d'un film formant barrière, comprenant les étapes consistant à :
traiter une surface d'un substrat avec un plasma réactif utilisant un gaz réactif dans un vide, et en l'espace des trois secondes qui suivent, alors que le substrat est toujours dans le vide ;
évaporer une composition de monomère d'acrylate, et condenser le monomère d'acrylate sur le substrat sous la forme d'un film de monomère ;
polymériser l'acrylate dans le film de monomère pour former une couche d'acrylate réticulé ;
appliquer une couche d'aluminium en un matériau formant barrière à l'oxygène au-dessus de la couche d'acrylate réticulé ; et
commuter le traitement par plasma sur la surface de la couche d'acrylate réticulé entre MARCHE et ARRET immédiatement avant application de la couche dudit matériau formant barrière pour faire varier la densité optique et la conductivité électrique de la couche formant barrière.

2. Procédé selon la revendication 1, comprenant les étapes consistant à :
tremper le substrat à une température inférieure à 10°C en-dehors du vide ;
introduire le substrat trempé dans un vide ; et
condenser le monomère d'acrylate sur une surface du substrat alors que la température de la surface du substrat est encore inférieure à 10°C.

3. Procédé selon la revendication 1, dans lequel le substrat comprend un matériau en feuille, comprenant les étapes consistant à :
faire venir en prise une première face du substrat avec un rouleau gelé ;
effectuer l'étape de traitement par plasma sur la première face ; et immédiatement après
déplacer le substrat par rapport à un poste de déposition pour déposer le monomère d'acrylate sur la première face ; et
réticuler le monomère sur la première face.

4. Procédé selon la revendication 3, comprenant en outre les étapes consistant à faire venir en prise l'autre face du substrat de matériau en feuille avec un tambour trempé et à faire tourner le tambour par rapport au poste de déposition pour déposer le monomère d'acrylate sur la première face.

5. Procédé selon la revendication 1, dans lequel le substrat non revêtu est un matériau en feuille et est **caractérisé par** l'étape consistant à mettre en prise une première face du substrat de matériau en feuille non revêtu avec un tambour trempé et à faire tourner le tambour par rapport à un poste de déposition pour déposer la composition de monomère d'acrylate sur une deuxième face du substrat de matériau en feuille non revêtu opposée à la première face, dans lequel le tambour est trempé à une température inférieure à -15°C.

6. Procédé selon la revendication 1,
**caractérisé en ce que** la composition de monomère d'acrylate comprend au moins l'un parmi le diacrylate d'hexanediol, le diacrylate de diéthylèneglycol, le diacrylate de propane, le diacrylate de butanediol, le diacrylate de tripropylèneglycol, le diacrylate de néopentylglycol, l'acrylate de phénoxyéthyle, l'acrylate d'isobornyle et l'acrylate de lauryle.

7. Procédé selon la revendication 1, dans lequel la composition de monomère d'acrylate comprend au moins l'un parmi le diacrylate de bisphénol A, l'acrylate de β-carboxyéthyle, l'acrylate d'amine, l'acide phosphorique acrylé et méthacrylé et le propoxytriacrylate de glycérol.
